# EUROPÄISCHE PATENTSCHRIFT

(11) **EP 2 616 315 B1**
(45) Veröffentlichungstag und Bekanntmachung des Hinweises auf die Patenterteilung: **07.09.2016**
(21) Anmeldenummer: 11754670.5
(22) Anmeldetag: 09.09.2011
(51) Int. Cl.: B63B 9/00, B63B 21/30, B63H 9/02, B63H 21/17

(54) **ELEKTROMOTOR-AUSTAUSCH**
ELECTRIC MOTOR EXCHANGE
ÉCHANGE DE MOTEUR ÉLECTRIQUE

(30) Priorität: 16.09.2010 DE 102010040907
(43) Veröffentlichungstag der Anmeldung: 24.07.2013
(73) Patentinhaber: Wobben Properties GmbH, 26607 Aurich (DE)
(72) Erfinder: ROHDEN, Rolf, 26607 Aurich (DE)
(74) Vertreter: Eisenführ Speiser
(86) Internationale Anmeldenummer: PCT/EP2011/065628
(87) Internationale Veröffentlichungsnummer: WO 2012/034938

(56) Entgegenhaltungen:
- EP-A1- 2 117 111
- WO-A2-2006/133950
- DE-A1-102008 018 420
- JP-A- 60 033 187
- US-A- 4 036 163

## Beschreibung

Die Erfindung betrifft ein Schiff mit mindestens einem Motor zum Antreiben des Schiffes und mit mindestens einem Kran.

Ferner betrifft die Erfindung ein Verfahren zum Austausch von Schiffs-Motoren, die innerhalb eines Schiffes zum Antreiben des Schiffes zusammen mit Peripheriegeräten angeordnet sind und mit einer Vortriebseinheit gekoppelt sind, wobei das Schiff mindestens eine verschließbare Öffnung und mindestens einen Kran aufweist.

Der Antrieb von Schiffen mittels Motoren oder Elektromotoren ist vielfältig bekannt. Bei Frachtschiffen kommen dabei meist großvolumig Dieselaggregate zum Einsatz. Bei kleineren Schiffen oder auch bei Segelschiffen werden teilweise auch Elektromotoren als Antrieb eingesetzt. Auch sind sogenannte dieselelektrische Antriebe bekannt, bei denen ein Elektromotor als Antrieb dient, die elektrische Energie für den Betrieb das Elektromotors jedoch mittels Dieselaggregaten umgewandelt wird.

Einen solchen Antrieb mittels Elektromotoren zeigt beispielsweise DE 10 2008 018 420 A1. In ihr ist eine Antriebseinrichtung für ein Schiff gemäß dem Oberbegriff von Anspruch 1 mit einer Antriebswelle zum Antrieb einer Vortriebseinheit des Schiffes in Form einer Schraube und mit einem ersten und einem zweiten elektrischen Motor zum Antrieb der Vortriebseinheit offenbart. Die beiden Motoren sind hintereinander auf der Antriebswelle angeordnet, wobei der Stromrichter zur Speisung der Motoren mit elektrischem Strom in dem Motorgehäuse des ersten Motors angeordnet ist. So kann ein Motor speziell für die Fahrt innerhalb eines Hafens ausgelegt werden, während der zweite Motor für die Schnellfahrt optimiert ist.

Fällt einer der Motoren aus, kann die Fahrt mit dem zweiten Motor fortgesetzt werden. Suboptimal ist, dass die Fahrt im Zweifelsfall mit einem Motor fortgeführt werden muss, der nicht für diesen Fahrmodus optimiert ist.

Ein weiteres Problem stellt die Wartung und Reparatur solcher Motoren dar. Sie werden üblicherweise an Bord des Schiffes gewartet und repariert, für dessen Antrieb sie eingerichtet sind. Dadurch muss das Schiff über den gesamten Zeitraum der Wartung oder der Reparatur in einem Hafen liegen und kann nicht genutzt werden. Dies verursacht insbesondere bei Frachtschiffen hohe Kosten, da nicht nur die Wartungs- und Reparaturkosten sowie die Liegekosten in dem Hafen anfallen, sondern auch die Kosten, die durch die Nichtnutzung des Schiffes entstehen zu berücksichtigen sind. Die Wartung oder Reparatur wird weiterhin dadurch erschwert, dass der Raum um die Motoren herum meist sehr beengt ist. Auch sind die Lichtverhältnisse in einem Schiffmaschinenraum nicht optimal.

Sind größere Reparaturen an den Schiffsmotoren vorzunehmen, werden diese teilweise auch ausgetauscht. Dazu müssen die Motoren regelmäßig demontiert und aus dem Schiff heraus befördert werden. Dies ist eine sehr zeit- und kostenintensive Tätigkeit

Aufgabe der vorliegenden Erfindung ist es daher, ein Schiff mit einem einfach und kostengünstig zu wartenden und zu reparierenden Motor bereitzustellen. Ferner ist es Aufgabe, einen energiesparenden und sicheren Antrieb für ein Schiff anzugeben.

Die vorliegende Erfindung löst die Aufgabe bei einem Schiff der eingangs genannten Art mit den Merkmalen von Anspruch 1.

Zum Anheben des Motors ist mindestens ein Kran durch mindestens eine verschließbare Öffnung hindurch mit dem mindestens einen Motor in Eingriff bringbar.

Bei einem erfindungsgemäßen Schiff ist es möglich, den Motor durch die verschließbare Öffnung aus dem Schiff mittels eines schiffseigenen Krans herauszuheben. Dadurch muss die Wartung oder Reparatur nicht mehr innerhalb des Maschinenraumes stattfinden, und es ist nicht mehr notwendig, einen hafen- oder werftseitigen Kran einzusetzen. Es ist erfindungsgemäß möglich, den defekten oder zu wartenden Motor mittels des Krans beispielsweise auf ein Deck des Schiffes zu heben und dort zu reparieren oder zu warten. Als Deck kommen hier das Hauptdeck, Wetterdeck sowie sämtliche Zwischendecks in Frage. Falls das Schiff andere oder weitere Decks aufweist, sind auch diese unter den Begriff Deck zu fassen. Auch ist es möglich den Motor in einen speziellen Reparaturraum oder einen Lagerraum des Schiffes zu befördern. Ein weiterer Vorteil ist, dass der defekte oder zu wartende Motor schnell gegen einen neuen austauschbar ist, sodass das Schiff die Fahrt nach einem kurzen Aufenthalt sofort fortsetzen kann. Ist kein Elektromotor verfügbar, kann auch ein Dieselmotor eingesetzt werden. Ein Vorteil, der sich durch den Einsatz von mehreren Motoren ergibt, ist der, dass das Schiff nicht manövrierunfähig wird, falls ein Motor defekt sein sollte. Die Fahrt kann mit dem zweiten, dritten usw. Motor fortgesetzt werden.

Der Kran umfasst sämtliche Arten von schiffseigenen Kränen. Meist weisen solche Kräne einen Arm oder einen Hebel sowie eine Vorrichtung zum Heben oder Halten von Gegenständen auf. Diese Vorrichtung kann beispielsweise ein Haken oder eine Kombination von mehreren Haken sein. Insbesondere könnte eine solche Vorrichtung eine Traverse sein, wie sie häufig zum Heben großvolumiger oder unhandlicher Lasten eingesetzt wird. Dabei ist das in Eingriff Bringen des Krans mit dem Motor so zu verstehen, dass im Wesentlichen die Vorrichtung zum Heben oder Halten mit dem Motor in Eingriff kommt. Erfindungsgemäß sind der Kran, Öffnung und Motor in Abhängigkeit von den jeweiligen Bauarten, Größen und Einbausituationen so relativ zueinander angeordnet, dass das Herausheben möglich ist.

Durch einen erfindungsgemäßen Schiffsantrieb wird die Wartung oder Reparatur, insbesondere die Herausnahme oder der Austausch von Motoren stark erleichtert. Da die Motoren selektiv aktivierbar sind, ist es möglich, auch nur einen der Motoren zu betreiben. Vorzugsweise stets der Motor zu betreiben, der innerhalb des Antriebsstrangs näher an der Vortriebseinheit angeordnet ist. Eine räumliche Nähe der Motoren erleichtert zusätzlich den Austausch. Erfindungsgemäß ist dabei jedem Motor mindestens ein, vorzugsweise eine Vielzahl eigener Stromrichter zugeordnet, die beabstandet von dem Motor angeordnet sind. Als Stromrichter kann hier jegliche passende Art Stromrichter wie beispielsweise Umrichter oder Wechselrichter zum Einsatz kommen. Bevorzugt ist es auch, Umrichter zu verwenden, wie sie von dem Betrieb in Windenergieanlagen bekannt sind. Je nach Ausführung können alternativ auch eingesetzt werden. Beabstandet angeordnet soll hier so verstanden werden, dass die Stromrichter nicht Teil des Motors oder eines Motorgehäuses sind, aber dennoch mit diesem elektrisch verbunden sind. Vorteilhaft an der Tatsache, dass jeder Motor über mindestens einen, vorzugsweise eine Vielzahl Stromrichter verfügt, ist, dass die Motoren und die Stromrichter unabhängig voneinander zu betreiben sind. Sollten ein oder mehrere Stromrichter defekt sein, kann die Fahrt mittels der weiteren Stromrichter fortgesetzt werden. Vorteilhaft an der Beabstandung der Stromrichter ist, dass diese bei einer Herausnahme der Motoren innerhalb des Schiffes verbleiben können. Dies ist insbesondere dann vorteilhaft, wenn ein defekter oder zu wartender Motor gegen einen neuen ausgetauscht werden soll.

Die Erfindung löst die Aufgabe ferner durch ein Verfahren der eingangs genannten Art mit den Schritten:
- Abkoppeln von mindestens einem Motor von der Vortriebseinheit und von dem mindestens einen weiteren Motor,
- Abkoppeln von mindestens einem Motor von den Peripheriegeräten,
- Lösen der lösbaren Verbindung von mindestens einem Motor mit dem Schiff,
- Öffnen der verschließbaren Öffnung des Schiffes,
- In Eingriff Bringen des Krans mit dem mindestens einen abgekoppelten und gelösten Motor,
- Herausheben oder Versetzen des Motors mittels des Krans (Anspruch 14).

Durch das erfindungsgemäße Verfahren wird die einfache Herausnahme oder der einfache Austausch von Motoren vorteilhaft beschrieben. Dabei ist es für die Erfindung nicht wesentlich in welcher Reihenfolge die einzelnen Schritte durchgeführt werden. Auch können sie wenigstens teilweise zeitgleich ablaufen. Auch die Wiederholung einzelner Schritte ist möglich und erfindungsgemäß.

Die Erfindung löst die Aufgabe ferner durch die Verwendung eines Windenergieanlagen-Generators, wobei der Generator motorisch betrieben ist, als Motor in einem erfindungsgemäßen Schiff oder in einem erfindungsgemäßem Verfahren oder als Elektromotor in einem erfindungsgemäßen Schiffsantrieb (Anspruch 17).

Dies ist besonders vorteilhaft, da solche Generatoren in einem motorischen Betrieb über die ausreichende Leistung verfügen, um auch größere Schiffe zu bewegen. Außerdem ist durch die spezielle Gestaltung solcher Motoren ein großer Drehzahlbereich der Vortriebseinheit auch ohne ein Getriebe möglich. Weiterhin wird die Aufgabe durch die Verwendung vorteilhaft gelöst, da solche Maschinen besonders energiesparend betrieben werden können und durch die langsame Drehzahl besonders verschleißarm sind. Außerdem ist die Geräuschentwicklung solcher Maschinen, auch aufgrund der langsamen Drehzahl, besonders gering, so dass kein spezieller oder zusätzlicher Motor für die Hafenfahrt vorgesehen werden muss.

Gemäß einer besonders bevorzugten Ausführungsform des Schiffes ist die verschließbare Öffnung mittels eines Lukendeckels oder einer herausnehmbaren Bodenplatte oder eines nach Art eines herausnehmbaren Zwischendecks gestalteten Elements oder einer Kombination von Lukendeckeln, Bodenplatten und/oder Zwischendecks verschließbar. Ein solches herausnehmbares Zwischendeck oder eine herausnehmbare Bodenplatte ermöglicht die gleichzeitige Nutzung des Decks oder der Platte als Fracht- und Staufläche sowie als Schutzabdeckung für die Motoren. Eine Luke ist insbesondere als Öffnung zu einem Hauptdeck oder Wetterdeck vorteilhaft, um die Motoren beispielsweise vor Wassereintritt zu schützen. Der Lukendeckel, die Bodenplatte oder das Zwischendeck sind vorteilhaft im Wesentlichen oberhalb der Motoren angeordnet. Weiterhin ist vorteilhaft, dass sie übereinander angeordnet sind und im geöffneten Zustand einen geraden, freien Schacht oder Weg von dem Deck bis zu den Motoren freigeben, durch welchen hindurch der Kran mit dem Motor in Eingriff bringbar ist.

Gemäß einer weiteren bevorzugten Ausführungsform weisen die Lukendeckel, Bodenplatten und/oder Zwischendecks Laschpunkte auf, um mit dem mindestens einen Kran in Eingriff zu kommen. Mithilfe der Laschpunkte ist es einfacher, die genannten Elemente anzuheben und/oder zu bewegen.

Gemäß einer weiteren bevorzugten Ausführungsform kann die verschließbare Öffnung mit Hilfe des Krans geöffnet und verschlossen werden. Dies ist insbesondere dann möglich, wenn die Lukendeckel, Bodenplatten oder Zwischendecks Laschpunkte aufweisen. Es ist erfindungsgemäß und vorteilhaft, dass der Kran dazu gestaltet ist, durch Anheben und Versetzen der Lukendeckel, Bodenplatten oder Zwischendecks die Motoren freizulegen.

Gemäß einer weiteren bevorzugten Ausführungsform ist der Kran dazu gestaltet, den mindestens einen Motor innerhalb oder außerhalb des Schiffes zu bewegen, insbesondere zu versetzen, auf eine Plattform des Schiffes oder auf eine Plattform außerhalb des Schiffes zu heben. Dadurch kann der Motor außerhalb des Maschinenraumes gewartet oder repariert werden, oder auch gegen einen anderen Motor ausgetauscht werden.

Gemäß einer weiteren bevorzugten Ausführungsform weisen die Motoren Laschpunkte auf. So lassen sich die Motoren mittels des Krans leichter transportieren. Die Laschpunkte können dabei angeschraubt oder angeschweißt sein. Sie können als Augen oder als Ausnehmungen in einem Motorgehäuse geformt sein. Sie können auch an einem Fundament des Motors angebracht sein, sodass der Motor mitsamt dem Fundament anzuheben ist.

Gemäß einer weiteren bevorzugten Ausführungsform sind die Motoren mittels einer lösbaren Verbindung an dem Schiff befestigt. Unter einer lösbaren Verbindung sind hier alle Verbindungen zu verstehen, die reversibel lösbar sind. So insbesondere Schraubverbindungen oder Steck- und Klemmverbindungen. Eine lösbare Verbindung erleichtert die Herausnahme des Motors sehr.

Gemäß einer weiteren bevorzugten Ausführungsform sind die Motoren auf einem Schienensystem angeordnet, sodass sich die Motoren im Innenraum des Schiffes verfahren lassen. Ein solches Schienensystem kann beispielsweise so gestaltet sein, dass die Motoren auch ohne Öffnen der verschließbaren Öffnung innerhalb des Schiffes getauscht werden können. So könnte beispielsweise die Reihenfolge der Motoren geändert werden. Auch ist ein Schienensystem vorteilhaft, falls die verschließbare Öffnung nicht direkt senkrecht oberhalb des Motors angeordnet ist und der Motor erst zu der Öffnung hinbewegt werden muss.

Gemäß einer bevorzugten Ausführungsform des Schiffsantriebs ist die Einheit zum Übertragen der Leistung eine Welle und der mindestens erste und zweite Elektromotor und die Vortriebseinheit sind auf dieser Welle angeordnet. Indem die Motoren auf einer gemeinsamen Welle angeordnet sind, entfällt insbesondere eine Kopplungseinheit wie beispielsweise ein Getriebe, die selektive Aktivierbarkeit der Motoren bleibt jedoch weiterhin bestehen. Dadurch, dass kein Getriebe notwendig ist, um die Leistung des mindestens ersten und zweiten Motors zusammenzuführen und auf die Vortriebseinheit zu leiten, ist der Antrieb besonders wartungsarm. Zusätzlich kann so eine kleinere Einbaugröße und ein geringeres Gewicht erreicht werden.

Gemäß einer weiteren bevorzugten Ausführungsform des Schiffsantriebs sind auf der Welle zwischen dem mindestens ersten und zweiten Elektromotor und/oder den Elektromotoren und der Vortriebseinheit Kupplungen angeordnet. Dadurch kann der Motor, der aktuell nicht in Betrieb ist von dem Antriebsstrang abgekuppelt werden. Besonders bevorzugt ist es die Motoren, die an einem distalen Ende der Welle bezogen auf die Vortriebseinheit angeordnet sind, abzukuppeln. Als Kupplungen können beispielsweise starre Kupplungen wie etwa eine Scheibenkupplung oder auch Ausgleichskupplungen wie etwa Wellengelenke zum Einsatz kommen. Daneben können auch schaltbare Kupplungen zum Einsatz kommen. Dies ist vorteilhaft, wenn das Schiff eine Steuereinrichtung aufweist, sodass die Kupplungen mittels einer Steuereinrichtung ferngeschaltet werden können.

Gemäß einer bevorzugten Ausführungsform des Schiffsantriebs sind die Elektromotoren als Ringmotoren mit einem innenlaufenden Rotor und einem in radialer Richtung außenliegenden Statorring ausgeführt. Ringmotoren eignen sich aufgrund ihrer Bauform besonders für einen solchen Antrieb eines Schiffes. Insbesondere sind dadurch Getriebe zum Wandeln eine Drehzahl nicht notwendigerweise vorzusehen, auch wenn dies je nach Ausführung bevorzugt sein kann.

Gemäß einer bevorzugten Ausführungsform des Schiffsantriebs sind die Elektromotoren im Wesentlichen baugleich. Dadurch wird die selektive Aktivierbarkeit weiter fortgebildet. Insbesondere wenn die Motoren baugleich sind, können sie sich im Wesentlichen vollständig ersetzen. Unter baugleich ist hier nicht zu verstehen, dass die Motoren identisch sein müssen. Dies ist schon aufgrund der Anordnung im Antriebsstrang nicht vorteilhaft. Unter baugleich wird vielmehr verstanden, dass die Motoren von einem im Wesentlichen gleichen Typ sind. Auch ist es vorteilhaft, wenn sie eine im Wesentlichen gleiche Leistung aufweisen. Weiterhin ist es vorteilhaft, wenn die Motoren im Wesentlichen die gleichen Anschlüsse für elektrische Energie und/oder weitere Peripheriegeräte aufweisen.

Gemäß einer bevorzugten Ausführungsform des Schiffsantriebs weisen die Elektromotoren eine Kühlvorrichtung auf. Durch die hohen Leistungen, die solche Motoren bereitstellen kommt es regelmäßig zu einer starken Erwärmung. Mittels einer Kühlung kann die Erwärmung reduziert werden, sodass einerseits das Material geschont wird und andererseits die Verlustleistung aufgrund der durch die Erwärmung erhöhten elektrischen Widerstände reduziert wird. Eine Kühlung kann hier in verschiedenster Form ausgeführt sein. Es sind alle üblichen Kühlungen, die von einem Fachmann vorgesehen werden können, in Betracht zu ziehen.

Gemäß einer bevorzugten Ausführungsform des Schiffsantriebs weisen die Stromrichter eine Kühlvorrichtung auf. Auch die Stromrichter wie etwa Umrichter oder Wechselrichter können durch die hohe abzugebende Leistung erwärmt werden. Auch hier ist eine Kühlvorrichtung vorteilhaft. Diese Kühlvorrichtung muss nicht die gleiche Kühlvorrichtung wie die der Motoren sein. Die beiden Kühlvorrichtungen können verschiedene Prinzipien nutzen. Sie müssen auch nicht in irgendeiner Art und Weise gekoppelt sein. Sie können völlig unabhängig voneinander vorgesehen und eingerichtet werden.

Gemäß einer bevorzugten Ausführungsform des Schiffsantriebs ist die Kühlvorrichtung eine Luftkühlvorrichtung. Indem die Kühlvorrichtung als eine Luftkühlvorrichtung ausgeführt wird, wird die Oxidation, die üblicherweise bei Wasserkühlungen auftritt, reduziert. Ein weiterer Vorteil einer Luftkühlung ist die geringere Wartung und geringere Fehleranfälligkeit. So kann im Falle eines Lecks in der Kühlvorrichtung kein Kühlwasser, Öl oder ein ähnliches Kühlmittel austreten. Bei einer Luftkühlvorrichtung gibt es verschiedene Möglichkeiten den Motor zu kühlen. Einerseits kann der Stator oder Statorring des Elektromotors mit Luft umströmt werden, oder es kann Luft durch den Spalt zwischen Stator und Rotor geleitet werden. Auch ist es möglich, Luft durch Öffnungen im Rotor zu leiten oder Kühlkanäle im Stator vorzusehen. Diese einzelnen Möglichkeiten können von einem Fachmann auch beliebig kombiniert werden. Gemäß einer weiteren bevorzugten Ausführungsform sind ist die Kühlvorrichtung eine Wasserkühlvorrichtung. Wasser hat gegenüber Luft den Vorteil, dass mehr Wärme von dem zu kühlenden Element wegtransportiert werden kann. Vorteilhaft wird diese Kühlmethode bei den Stromrichtern eingesetzt.

Gemäß einer bevorzugten Ausführungsform des Schiffsantriebs ist dieser in einem erfindungsgemäßen Schiff angeordnet. Durch einen solchen Schiffsantrieb können die Vorteile des erfindungsgemäßen Schiffs weiter vorteilhaft genutzt werden.

Gemäß einer bevorzugten Ausführungsform des Verfahrens zum Austausch von Schiffs-Motoren werden die ersten vier Schritte in vertauschter Reihenfolge ausgeführt. Die ersten vier Schritte betreffen das Abkoppeln der Motoren von einem Antrieb und von den Peripheriegeräten, sowie das Lösen der lösbaren Verbindung und das Öffnen der verschließbaren Öffnung. Es ist ersichtlich und vorteilhaft, dass diese Schritte nicht stets in dieser Reihenfolge durchzuführen sind. Es kann, je nach vorliegendem Wartungs-, Reparatur- oder sonstigem Problem, sowie je nach verfügbarere Arbeitskraft oder ähnlichem vorteilhaft sein, die Schritte in geänderter Reihenfolge durchzuführen. Im Zweifelsfall können auch einer oder mehrere dieser Schritte entfallen oder durch andere Schritte ersetzt werden. Unter Abkoppeln von einem Antrieb ist hier zu verstehen, dass der betreffende Motor nicht mehr an einen Antriebsstrang gekoppelt ist.

Gemäß einer weiteren bevorzugten Ausführungsform des Verfahrens weist das Verfahren zusätzlich den Schritt "Hineinheben oder Hinversetzen eines Motors mittels des Krans" auf. Die Einführung eines solchen Schrittes ist vorteilhaft, wenn ein Motor ausgetauscht werden soll. Auch ist es vorteilhaft wenn in einem benachbarten Bereich zu dem Antriebsstrang ein Motor angeordnet ist, der zu dem Antriebsstrang hinversetzt werden soll. Die Einführung weiterer ähnlicher Schritte ist ebenfalls möglich. So ist mit diesem Schritt auch das alleinige Tauschen der Motoren umfasst. Auch das Hineinheben oder Hinversetzen von Peripheriegeräten kann vorteilhaft sein und soll umfasst werden.

Gemäß einer weiteren bevorzugten Ausführungsform des Verfahrens weist das Verfahren zusätzlich den Schritt "Schließen der verschließbaren Öffnung" auf. Das Schließen der verschließbaren Öffnung ist beispielsweise nach vollendetem Herausnehmen eines Motors vorteilhaft. Durch das Schließen ist es möglich, das Schiff wieder voll zu nutzen und die Fahrt auf offenen Gewässern fortzusetzen. Im Zweifelsfall kann aber eine Fahrt auch mit nicht verschlossener Öffnung fortgesetzt werden.

Gemäß einer weiteren bevorzugten Ausführungsform des Verfahrens wird dieses Verfahren bei einem erfindungsgemäßen Schiff oder bei einem erfindungsgemäßen Schiffsantrieb eingesetzt. Dadurch werden die genannten Vorteile des erfindungsgemäßen Schiffs und des erfindungsgemäßen Schiffsantriebs weiter vorteilhaft genutzt.

Gemäß einer bevorzugten Ausführungsform der Verwendung eines Windenergieanlagen-Generators als Motor in einem Schiff werden mehrere solcher Maschinen verwendet, die im Wesentlichen baugleich sind. Dadurch wird der selektive Antrieb weiter fortgebildet. Nur wenn die Maschinen baugleich sind, können sie sich im Wesentlichen vollständig ersetzen. Unter baugleich ist hier nicht zu verstehen, dass die Maschinen identisch sein müssen. Dies ist schon aufgrund der Anordnung im Antriebsstrang nicht vorteilhaft. Unter baugleich wird vielmehr verstanden, dass die Maschinen von einem im Wesentlichen gleichen Typ sind. Auch ist es vorteilhaft, wenn sie eine im Wesentlichen gleiche Leistung aufweisen. Weiterhin ist es vorteilhaft, wenn die Maschinen im Wesentlichen die gleichen Anschlüsse für elektrischen Strom und/oder weitere Peripheriegeräte aufweisen.

Die Erfindung ist nachstehend anhand eines Ausführungsbeispiels unter Bezugnahme auf die beiliegenden Zeichnungen beschrieben. Es zeigen:
- Figur 1: ein Heck eines erfindungsgemäßen Schiffs in einer teilweise aufgebrochenen Seitenansicht;
- Figur 2: eine weitere perspektivische Ansicht des erfindungsgemäßen Schiffs aus Figur 1;
- Figur 3: einen erfindungsgemäßen Schiffsantrieb;
- Figur 4: eine schematische Darstellung des Schiffsantriebs aus Figur 3.

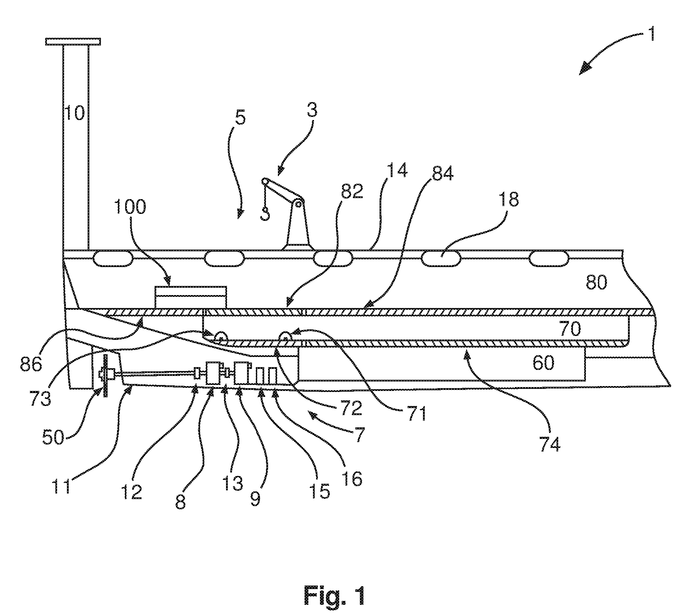

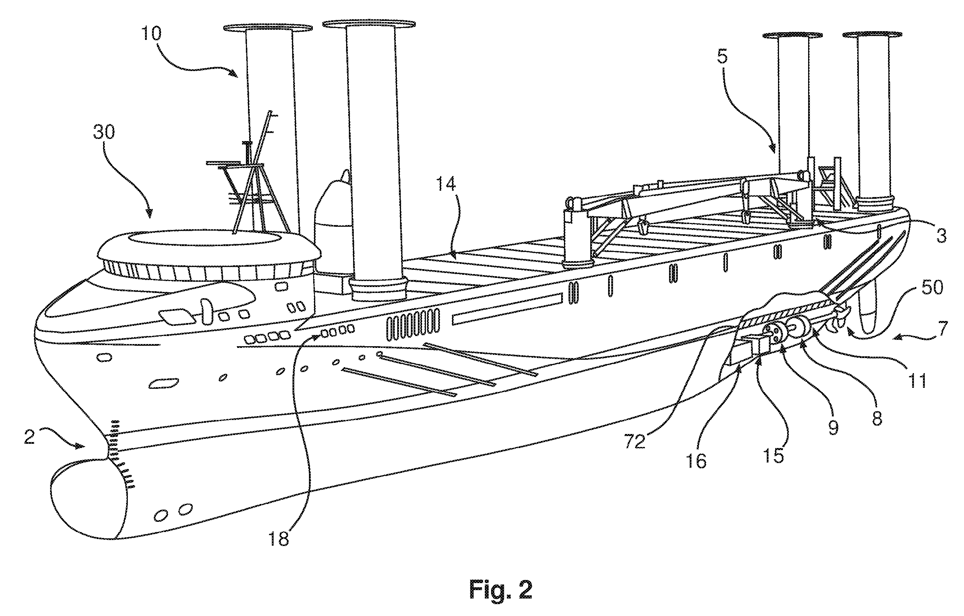

Das in Figur 1 gezeigte Heck des Schiffs 1 weist einen Rumpf 2, einen Kran 3 (in Figur 1 nur schematisch dargestellt), eine verschließbare Öffnung 5 sowie einen Schiffsantrieb 7 auf. Hierbei sind Magnus-Rotoren 10 zu erkennen, die als ein Segelantrieb des Schiffes 1 genutzt werden. Magnus-Rotoren werden auch als Flettner-Rotoren oder Segel-Rotoren bezeichnet. Die Magnus-Rotoren 10 sind jeweils in den vier Ecken des durch das Wetterdeck 14 aufgespannten Rechtecks an dem Rumpf 2 angeordnet (Figur 2). In Figur 2 sind zwei Kräne dargestellt, wobei nur ein Kran 3 benachbart zu der verschließbaren Öffnung 5 angeordnet ist. Der in Figur 2 gezeigte Kran ist gegenüber dem in Figur 1 wesentlich bevorzugt. In Figur 2 ist darüberhinaus die Brücke 30 des Schiffs 1 gezeigt Das Wetterdeck 14 weist Lichtöffnungen 18 auf, die zum Schutz vor Witterungseinflüssen bzw. Seewasser mit transparentem Material abgedeckt sein können. Ferner sind die drei Ladedecks, d. h. ein Unterraum 60, ein erstes Zwischendeck 70 und ein zweites Zwischendeck 80 gezeigt. Das Schiff weist eine Vortriebseinheit 50 auf, die hier als Schraube dargestellt ist. Für eine verbesserte Manövrierfähigkeit kann das Schiff 1 ebenfalls Querstrahlruder aufweisen, wobei vorzugsweise eines am Heck und eines bis zwei Querstrahlruder am Bug vorgesehen sind. Vorzugsweise sind diese Querstrahlruder elektrisch angetrieben. Die Unterkünfte, Kombüse, Provianträume, Messen usw. sind im Deckshaus 40 angeordnet.

Die Zwischendecks 60, 80 sind nach unten hin durch einen Boden begrenzt. Dabei besteht der Boden des ersten Zwischendecks 70 in diesem Ausführungsbeispiel aus einer herausnehmbaren Bodenplatte 72 sowie einer ortsfesten Bodenplatte 74. Der Boden des zweiten Zwischendecks 80 weist drei Abschnitte auf: eine herausnehmbare Bodenplatte 82, eine erste ortsfeste Bodenplatte 84 sowie eine zweite ortsfeste Bodenplatte 86. Indem die beiden herausnehmbaren Bodenplatten 72, 82 herausgenommen, oder verschoben werden wird die verschließbare Öffnung 5 geöffnet. Die beiden herausnehmbaren Bodenplatten 72, 82 sind hier so übereinander angeordnet, dass der Weg, der durch sie verschlossen wird, im Wesentlichen senkrecht über dem Schiffsantrieb 7 angeordnet ist. Der Kran 3 ist dabei so auf dem Deck 14 angeordnet, dass er durch die verschließbare Öffnung 5 mit dem Schiffsantrieb 7 in Eingriff bringbar ist. Sind die herausnehmbaren Bodenplatten 72, 82 nicht herausgenommen, versperren sie also die verschließbare Öffnung 5, können die Zwischendecks 70, 80 normal mit Fracht 100 beladen werden. In diesem Ausführungsbeispiel müssen zum Öffnen der verschließbaren Öffnung 5 also nicht nur die herausnehmbaren Bodenplatten 72, 82 herausgenommen werden, sondern es muss auch eventuell auf den herausnehmbaren Bodenplatten 72, 82 gelagerte Fracht 100 aus dem Abschnitt der verschließbaren Öffnung 5 entfernt werden. Dazu ist es weiter vorteilhaft, wenn die Bodenplatten Laschpunkte 71, 73 aufweisen, sodass sie mit Hilfe des Krans 3 herausgenommen werden können. Insbesondere ist vorteilhaft, wenn die Bodenplatte mit Hilfe einer Traverse herausnehmbar ist. In einer alternativen Ausführungsform (hier nicht dargestellt) wirken die herausnehmbaren Bodenplatten mit einem Schienensystem zusammen, sodass sie zur Öffnung der verschließbaren Öffnung 5 verschoben werden können.

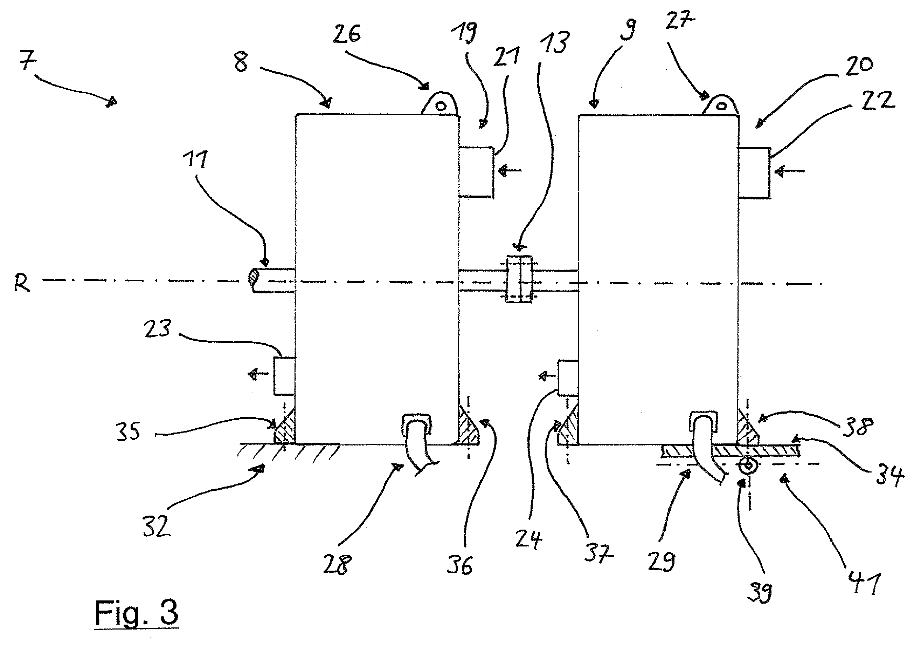

Der Schiffsantrieb 7 ist hier in einem unteren, hinteren Bereich des Rumpfes 2 angeordnet. Der Schiffsantrieb weist in dem Ausführungsbeispiel zwei Motoren 8, 9, zwei Stromrichter-Schränke 15, 16 mit insgesamt 56 Stromrichtern, zwei Kupplungen 12, 13, eine Welle 11 sowie eine Vortriebseinheit 50, die hier als Schraube ausgeführt ist, auf (Figuren 1 bis 4). Jedem der Motoren 8, 9 ist dabei einer der Stromrichter-Schränke 15, 16 zugeordnet. Die Stromrichter-Schränke 15, 16 sind beabstandet zu den Motoren 8, 9 angeordnet. So wird es möglich die Motoren 8, 9 auch ohne Stromrichter-Schränke 15, 16 aus dem Schiff 1 herauszuheben oder einen Motor 8, 9 auszutauschen ohne gleich den entsprechenden Stromrichter-Schrank 15, 16 mit auszutauschen. Zudem können die Motoren 8, 9 so unabhängig voneinander betrieben werden. Da der Schiffsantrieb 7 in einem hinteren Bereich des Rumpfes angeordnet ist, kann die Welle 11 kurz ausgeführt werden und muss nicht durch das gesamte Schiff geführt werden. Die Welle 11 bildet hier die gemeinsame Welle für die Motoren 8, 9 und die Vortriebseinheit 50. Dies wird auch durch die Mittellinie R in Figur 3 angedeutet. Die Motoren 8, 9 könnten auch parallel angeordnet sein (hier nicht dargestellt). Dann müsste ein Getriebe zwischen den Motoren 8, 9 und der Vortriebseinheit 50 vorgesehen werden, um die Abtriebsleistung der Motoren 8, 9 zu koppeln und auf die Vortriebseinheit 50 zu leiten. Da Getriebe oft einen erhöhten Wartungsaufwand darstellen ist die hier gezeigte Ausführungsform bevorzugt.

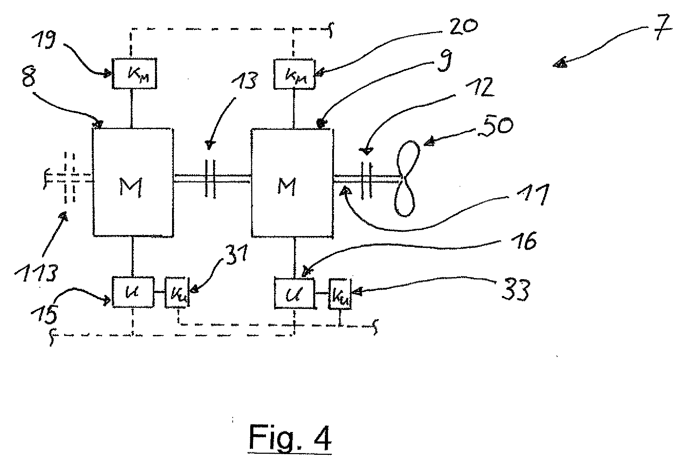

Zwischen den Motoren 8, 9 sowie zwischen dem zweiten Motor 8 und der Vortriebseinheit 50 sind auf der Welle 11 jeweils Kupplungen 12, 13 angeordnet (Figuren 1, 3 und 4). In Figur 3 ist die Kupplung 13 zwischen den beiden Motoren 8, 9 als eine drehsteife Ganzmetallkupplung wie bspw. eine Stahlflex-Kupplung ausgeführt. Hier kann es je nach Ausführungsform ebenso vorteilhaft sein eine Ausgleichskupplung vorzusehen. Auf der linken Seite der Figur 3 ist die Welle 11 abgebrochen dargestellt. Hierdurch wird verdeutlicht, dass nach dem zweiten Motor 8 einerseits die Vortriebseinheit 50 auf der Welle 11 angeordnet sein kann, es ist jedoch auch möglich hier einen dritten, vierten usw. Motor anzuordnen. Schematisch ist dies auch in Figur 4 verdeutlicht, indem neben dem zweiten Motor 8 eine Kupplung 113 gestrichelt dargestellt ist.

Figur 3 zeigt neben den Motoren 8, 9, der Welle 11 und der Kupplung 13 auch Kühlvorrichtungen 19, 20, Laschpunkte 26, 27 und die lösbare Verbindung 35, 36, 37, 38 mit der die Motoren 8, 9 an einem Fundament 32 (nur angedeutet dargestellt) verbunden sind. Die Motoren 8, 9 sind hier als im Wesentlichen baugleiche Motoren gezeigt. Dabei ist jedem Motor 8, 9 eine Kühlvorrichtung 19, 20 zugeordnet. Die Kühlvorrichtungen 19, 20 sind hier als Luftkühlvorrichtungen ausgeführt. In einem oberen Bereich der Motoren 8, 9 sind die Lufteinlässe 21, 22 angeordnet, in einem unteren Bereich die Luftauslässe 23, 24. Die Pfeile vor den Luftein- und -auslässen verdeutlichen den Luftstrom durch den Motor 8, 9. Die Kühlvorrichtungen 19, 20 können auf eine Art und Weise gekoppelt sind, oder auch unabhängig voneinander vorgesehen werden. Dies wird auch in Figur 4 durch die gestrichelte Linie, die die beiden Kühlvorrichtungen 19, 20 verbindet, verdeutlicht. Die auf der rechten Seite abgebrochene gestrichelte Linie deutet an, dass die Kühlvorrichtungen 19, 20 auch mit einer zentralen Kühlvorrichtung gekoppelt sein können. Es kann in Einzelfällen auch vorteilhaft sein keine Kühlvorrichtung vorzusehen.

In einem unteren Abschnitt der Motoren 8, 9 in Figur 3 sind unterhalb der Luftauslässe 23, 24 die lösbaren Verbindungen 35, 36, 37, 38 angeordnet. Diese sind hier als Schraubverbindungen zwischen einem Fortsatz des Motors 8, 9 bzw. eines Motorgehäuses und dem Fundament 32 ausgeführt. Auch wenn in Figur 3 nur vier Schraubverbindungen 35, 36, 37, 38 gezeigt sind, können die Motoren 8, 9 eine Vielzahl von Schraubverbindungen oder anderen lösbaren Verbindungen mit einem Fundament 32 aufweisen. Die Fortsätze könnten auch in einem mittleren oder oberen Abschnitt der Motoren 8, 9 angeordnet sein, sodass diese teilweise in dem Fundament 32 eingelassen sind. Es ist ebenfalls möglich zwischen dem Fundament 32 und den Schraubverbindungen 35, 36, 37, 38 Dämpfungselemente oder anderen Zwischenelemente vorzusehen. In einer alternativen Ausführungsform (auf der rechten Seite von Figur 3, unterhalb von Motor 9 dargestellt) sind die Motoren 8, 9 auf einem Schienensystem 41angeordnet. Hier ist das Schienensystem 41 als unterhalb eines Bodens 34 liegend dargestellt. Die lösbare Verbindung 38 wirkt hier mit einer Rolle 39 zusammen, die wiederum mit dem Schienensystem 41 zusammenwirkt. Es ist auch möglich das Schienensystem 41 oberhalb des Bodens 34 oder teilweise versenkt in ihn anzuordnen. Auch ist es denkbar, dass die Motoren 8, 9, falls sie auf einem solchen Schienensystem 41 gelagert sind, eine Brems- oder Feststellvorrichtung aufweisen.

In einem oberen Abschnitt weisen die Motoren 8, 9 Laschpunkte 26, 27 auf. Sie dienen dazu mit dem Kran 3 in Eingriff gebracht zu werden. So können die Motoren mit Hilfe des Krans 3 angehoben oder versetzt werden. Hier könnten auch je nach Gewicht, Größe und Form der Motoren 8, 9 mehr als zwei Laschpunkte vorgesehen werden. Auch können die Laschpunkte 26, 27 eine andere Form als die hier dargestellte Form aufweisen. In einer alternativen Ausführungsform sind die Laschpunkte 26, 27 mit dem Fundament 32 verbunden, sodass die Motoren 8, 9 mitsamt dem Fundament 32 angehoben werden können. In einer weiteren alterativen Ausführungsform ist das oben genannte Schienensystem 41 an dem Fundament 32 angeordnet, sodass die Motoren 8, 9 mitsamt dem Fundament 32 auf dem Schienensystem 41 verschiebbar sind.

In Figur 3 weisen die Motoren 8, 9 in einem unteren Abschnitt jeweils einen Anschluss 28, 29 für einen Stromrichter 15, 16 oder andere Peripheriegeräte auf. Der Anschluss 28, 29 muss nicht notwendigerweise in einem unteren Bereich der Motoren 8, 9 angeordnet sein. Auch kann er eine gänzlich andere Form aufweisen. Zudem können mehr als nur ein Anschluss je Motor 8, 9 vorgesehen werden. Über den Anschluss 28, 29 können die Stromrichter 15, 16 beabstandet zu den Motoren 8, 9 angeordnet werden. Den Stromrichtern 15, 16 können Kühlvorrichtungen 31, 33 zugeordnet sein (Figur 4). Die Kühlvorrichtung 31, 33 der Stromrichter bzw. Stromrichter-Schränke 15, 16 muss nicht die gleiche Kühlvorrichtung 19, 20 wie die der Motoren 8, 9 sein. Die gestrichelte Linie in Figur 4, die die Kühlvorrichtungen 31, 33 der Stromrichter-Schränke 15, 16 verbindet, deutet den gleichen funktionalen Zusammenhang an, wie die gestrichelte Linie, die die Kühlvorrichtungen 19, 20 der Motoren 8, 9 verbindet.

Die Stromrichter-Schränke 15, 16 sind unabhängig voneinander je einem Motor 8, 9 zugeordnet (Figur 4). Hier sind sie mit einer gestrichelten Linie verbunden. Sie deutet an, dass die Stromrichter-Schränke 15, 16 auch in einer Art und Weise zusammenwirken können. Dieses Zusammenwirken könnte in einer Ausführungsform beispielsweise über eine gemeinsame Stromversorgung ausgeführt sein.

Ist es erforderlich einen der Motoren 8, 9, etwa den ersten Motor 9, herauszunehmen, beispielsweise aufgrund von einer anstehenden Wartung, einer Reparatur oder eines Austauschs gegen einen anderen Motor, wobei die Gründe hierfür vielfältig sein können, kann in dem Ausführungsbeispiel wie folgt vorgegangen werden: Zunächst könnte der Motor 9 von dem Schiffsantrieb 7 abgekoppelt werden. Hierfür ist es erforderlich die Kupplung 13 zu lösen. Desweiteren muss der Anschluss 29 von dem Motor getrennt werden. Auch die lösbaren Verbindungen 37, 38 sind zu lösen. Ist das Deck 14 geöffnet, kann der Kran 3 mit der ersten herausnehmbaren Bodenplatte 82 in Eingriff gebracht werden, um diese zu entfernen. Sollte auf dieser Bodenplatte 82 Fracht 100 gelagert sein, müsste diese zunächst in einen anderen Abschnitt des Zwischendecks 80 gebracht werden. Ist die erste herausnehmbare Bodenplatte 82 entfernt, kann der Kran 3 durch die Öffnung hindurch mit der zweiten herausnehmbaren Bodenplatte 72, beispielsweise mit Hilfe der Laschpunkte 73, in Eingriff gebracht werden. Ist auch diese entfernt, ist die verschließbare Öffnung 5 geöffnet und der Kran 3 kann als nächstes mit dem Laschpunkt 27 des Motors 9 in Eingriff gebracht werden. Nun kann der Motor 9 mit Hilfe des Krans 3 angehoben werden. Der Kran 3 kann den Motor 9 beispielsweise auf das erste Zwischendeck 70, das zweite Zwischendeck 80 oder auf das Deck 14 oder auch auf eine Plattform außerhalb des Schiffes 1 befördern. Ist der Motor 9 an dem Zielort angelangt, können die herausnehmbaren Bodenplatten 72, 82 mit Hilfe des Krans 3 wieder an ihren Ursprungsort zurückbewegt werden und die verschließbare Öffnung 5 ist somit verschlossen. Das Schiff 1 kann seine Fahrt mit dem Motor 8 weiter fortsetzen, während der andere Motor 9 gewartet, repariert o.ä. wird.

## Patentansprüche

1. Schiff (1) mit einem Schiffsantrieb (7) zum Antreiben des Schiffs (1), wobei der Schiffsantrieb eine Vortriebseinheit (50), mindestens einen ersten und einen zweiten Elektromotor (8, 9) und eine Einheit zum Übertragen der Leistung der Elektromotoren auf die Vortriebseinheit aufweist, sodass die Elektromotoren (8, 9) selektiv oder gemeinsam zu Betreiben sind,
**dadurch gekennzeichnet, dass** jedem Elektromotor (8, 9) mindestens ein, vorzugsweise eine Vielzahl Stromrichter (15, 16) zugeordnet sind, und die Stromrichter (15, 16) beabstandet zu dem Elektromotor (8, 9) angeordnet sind,
und mit mindestens einem Kran (3),
wobei zum Anheben des Motors (8, 9) mindestens ein Kran (3) durch mindestens eine verschließbare Öffnung (5) hindurch mit dem mindestens einen Motor (8, 9) in Eingriff bringbar ist.

2. Schiff nach Anspruch 1,
**dadurch gekennzeichnet, dass** die verschließbare Öffnung (5) mittels eines Lukendeckels oder einer herausnehmbaren Bodenplatte oder eines nach Art eines herausnehmbaren Zwischendecks gestalteten Elements oder einer Kombination von Lukendeckeln, Bodenplatten und/oder Zwischendecks (72, 82) verschließbar ist.

3. Schiff nach Anspruch 1 oder 2,
**dadurch gekennzeichnet, dass** die Lukendeckel, Bodenplatten und/oder Zwischendecks (72, 82) Laschpunkte (73) aufweisen, um mit dem mindestens einen Kran (3) in Eingriff zu kommen.

4. Schiff nach einem der vorstehenden Ansprüche,
**dadurch gekennzeichnet, dass** die verschließbare Öffnung (5) mit Hilfe des Krans (3) geöffnet und verschlossen werden kann.

5. Schiff nach einem der vorstehenden Ansprüche,
**dadurch gekennzeichnet, dass** der Kran (3) dazu gestaltet ist, den mindestens einen Motor (8, 9) innerhalb oder außerhalb des Schiffes (1) zu bewegen, insbesondere zu versetzen, auf eine Plattform des Schiffes (1) oder auf eine Plattform außerhalb des Schiffes (1) zu heben.

6. Schiff nach einem der vorstehenden Ansprüche,
**dadurch gekennzeichnet, dass** die Motoren (8, 9) Laschpunkte (26, 27) aufweisen und/oder mittels einer lösbaren Verbindung (35, 36, 37, 38) an dem Schiff (1) befestigt sind.

7. Schiff nach einem der vorstehenden Ansprüche,
**dadurch gekennzeichnet, dass** die Motoren (8, 9) auf einem Schienensystem (41) angeordnet sind, sodass sich die Motoren (8, 9) im Innenraum des Schiffes (1) verfahren lassen.

8. Schiff nach einem der vorstehenden Ansprüche,
**dadurch gekennzeichnet, dass** die Einheit zum Übertragen der Leistung eine Welle (11) ist und der mindestens erste und zweite Elektromotor (8, 9) und die Vortriebseinheit (50) auf dieser Welle (11) angeordnet sind.

9. Schiff nach Anspruch 8,
**dadurch gekennzeichnet, dass** auf der Welle (11) zwischen dem mindestens ersten und zweiten Elektromotor (8, 9) und/oder den Elektromotoren (8, 9) und der Vortriebseinheit (50) Kupplungen (12, 13) angeordnet sind.

10. Schiff nach einem der vorstehenden Ansprüche,
**dadurch gekennzeichnet, dass** die Elektromotoren (8, 9) als Ringmotoren mit einem innenlaufenden Rotor und einem in radialer Richtung außenliegenden Statorring ausgeführt sind.

11. Schiff nach einem der vorstehenden Ansprüche,
**dadurch gekennzeichnet, dass** die Elektromotoren (8, 9) im Wesentlichen baugleich sind.

12. Schiff nach einem der vorstehenden Ansprüche,
**dadurch gekennzeichnet, dass** die Elektromotoren (8, 9) eine Kühlvorrichtung (19, 20) aufweisen, welche insbesondere eine Luftkühlvorrichtung und/oder eine Wasserkühlvorrichtung ist.

13. Schiff nach einem der vorstehenden Ansprüche,
**dadurch gekennzeichnet, dass** die Stromrichter (15, 16) eine Kühlvorrichtung (31, 33) aufweisen, welche insbesondere eine Luftkühlvorrichtung und/oder eine Wasserkühlvorrichtung ist.

14. Verfahren zum Austausch von Schiffs-Motoren (8, 9), die innerhalb eines Schiffes (1) zum Antreiben des Schiffes (1) zusammen mit Peripheriegeräten angeordnet sind, mit einer Vortriebseinheit (50) gekoppelt sind und mit einer lösbaren Verbindung (35, 36, 37, 38) an dem Schiff (1) befestigt sind, wobei das Schiff (1) ein Schiff nach Anspruch 1 ist,
**gekennzeichnet durch** die Schritte
- Abkoppeln von mindestens einem Motor (8, 9) von der Vortriebseinheit (50) und von dem mindestens einen weiteren Motor (8, 9),
- Abkoppeln von mindestens einem Motor (8, 9) von den Peripheriegeräten,
- Lösen der lösbaren Verbindung (35, 36, 37, 38) von mindestens einem Motor (8, 9) mit dem Schiff (1),
- Öffnen der verschließbaren Öffnung (5) des Schiffes (1),
- In Eingriff Bringen des Krans (3) mit dem mindestens einen abgekoppelten und gelösten Motor (8, 9),
- Herausheben oder Versetzen des Motors (8, 9) mittels des Krans (3).

15. Verfahren nach Anspruch 14,
**dadurch gekennzeichnet, dass** die ersten vier Schritte in vertauschter Reihenfolge ausgeführt werden.

16. Verfahren nach Anspruch 14,
**dadurch gekennzeichnet, dass** das Verfahren zusätzlich den Schritt
- Hineinheben oder Hinversetzen eines Motors (8, 9) mittels des Krans (3); und/oder
- Schließen der verschließbaren Öffnung (5)
aufweist.

17. Verwendung eines Windenergieanlagen-Generators, wobei der Generator motorisch betrieben ist, als Motor (8, 9) in einem Schiff (1) nach den Ansprüchen 1 bis 8 oder in einem Verfahren nach den Ansprüchen 14 bis 16.

## Claims

1. Ship (1) having a ship drive (7) for driving the ship (1), wherein the ship drive has a propulsion unit (50), at least a first and a second electric motor (8, 9) and a unit for transmitting the power of the electric motors to the propulsion unit so that the electric motors (8, 9) are able to be operated selectively or together,
**characterised in that** there are associated with each electric motor (8, 9) at least one, preferably a large number of, power converter(s) (15, 16) and the power converters (15, 16) are arranged spaced apart from the electric motor (8, 9),
and having at least one crane (3),
wherein in order to drive the motor (8, 9) at least one crane (3) can be moved into engagement with the at least one motor (8, 9) through at least one closable opening (5).

2. Ship according to claim 1,
**characterised in that** the closable opening (5) can be closed by means of a hatch cover or a base plate which can be removed or an element which is configured in the manner of a removable intermediate deck or a combination of hatch covers, base plates and/or intermediate decks (72, 82).

3. Ship according to claim 1 or claim 2,
**characterised in that** the hatch cover, base plate and/or intermediate decks (72, 82) have lashing locations (73) in order to move into engagement with the at least one crane (3).

4. Ship according to any one of the preceding claims,
**characterised in that** the closable opening (5) can be opened and closed using the crane (3).

5. Ship according to any one of the preceding claims,
**characterised in that** the crane (3) is configured to move the at least one motor (8, 9) inside or outside the ship (1), in particular to displace it, to lift it onto a platform of the ship (1) or onto a platform outside the ship (1).

6. Ship according to any one of the preceding claims,
**characterised in that** the motors (8, 9) have lashing locations (26, 27) and/or are secured to the ship (1) by means of a releasable connection (35, 36, 37, 38).

7. Ship according to any one of the preceding claims,
**characterised in that** the motors (8, 9) are arranged on a rail system (41) so that the motors (8, 9) can be moved in the inner space of the ship (1).

8. Ship according to any one of the preceding claims,
**characterised in that** the unit for transmitting the power is a shaft (11) and the at least first and second elector motors (8, 9) and the propulsion unit (50) are arranged on this shaft (11).

9. Ship according to claim 8,
**characterised in that** couplings (12, 13) are arranged on the shaft (11) between the at least first and second electric motors (8, 9) and/or the electric motors (8, 9) and the propulsion unit (50).

10. Ship according to any one of the preceding claims,
**characterised in that** the electric motors (8, 9) are constructed as ring motors with an internal rotor and a stator ring which is located at the outer side in a radial direction.

11. Ship according to any one of the preceding claims,
**characterised in that** the electric motors (8, 9) are substantially structurally identical.

12. Ship according to any one of the preceding claims,
**characterised in that** the electric motors (8, 9) have a cooling device (19, 20) which is in particular an air cooling device and/or a water cooling device.

13. Ship according to any one of the preceding claims,
**characterised in that** the power converters (15, 16) have a cooling device (31, 33) which is in particular an air cooling device and/or a water cooling device.

14. Method for replacing ship motors (8, 9) which are arranged inside a ship (1) for driving the ship (1) together with peripheral devices, which are coupled to a propulsion unit (50) and which are secured to the ship (1) by means of a releasable connection (35, 36, 37, 38), wherein the ship (1) is a ship according to claim 1,
**characterised by** the steps
- uncoupling at least one motor (8, 9) from the propulsion unit (50) and from the at least one additional motor (8, 9),
- uncoupling at least one motor (8, 9) from the peripheral devices,
- releasing the releasable connection (35, 36, 37, 38) of at least one motor (8, 9) to the ship (1),
- opening the closable opening (5) of the ship (1),
- bringing the crane (3) into engagement with the at least one uncoupled and released motor (8, 9),
- removing or displacing the motor (8, 9) using the crane (3).

15. Method according to claim 14,
**characterised in that** the first four steps are carried out in reverse order.

16. Method according to claim 14,
**characterised in that** the method additionally has the step of
- lifting in or transferring a motor (8, 9) using the crane (3); and/or
- closing the closable opening (5).

17. Use of a wind turbine generator, wherein the generator is driven in a motorised manner, as a motor (8, 9) in a ship (1) according to claims 1 to 8 or in a method according to claims 14 to 16.

## Revendications

1. Navire (1) comprenant un système d'entraînement de navire (7) servant à entraîner le navire (1), dans lequel le système d'entraînement de navire présente une unité de propulsion (50), au moins un premier et un deuxième moteur électrique (8, 9) et une unité servant à transmettre la puissance des moteurs électriques sur l'unité de propulsion de sorte que les moteurs électriques (8, 9) sont à faire fonctionner de manière sélective ou conjointement,
**caractérisé en ce qu'**au moins un convertisseur, de préférence une pluralité de convertisseurs (15, 16) sont associés à chaque moteur électrique (8, 9), et **en ce que** les convertisseurs (15, 16) sont disposés à distance du moteur électrique (8, 9),
et **en ce que** le navire comprend également au moins une grue (3),
dans lequel au moins une grue (3) peut être amenée en prise par au moins une ouverture (5) pouvant être fermée avec l'au moins un moteur (8, 9) afin de soulever le moteur (8, 9).

2. Navire selon la revendication 1,
**caractérisé en ce que** l'ouverture (5) pouvant être fermée peut être fermée au moyen d'une écoutille ou d'un panneau de sol pouvant être retiré ou d'un élément configuré à la manière d'un pont intermédiaire pouvant être retiré ou d'une combinaison d'écoutilles, de panneaux de sol et/ou de ponts intermédiaires (72, 82).

3. Navire selon la revendication 1 ou 2,
**caractérisé en ce que** l'écoutille, les panneaux de sol et/ou les ponts intermédiaires (72, 82) présentent des points à attache (73) afin de venir en prise avec l'au moins une grue (3).

4. Navire selon l'une quelconque des revendications précédentes,
**caractérisé en ce que** l'ouverture (5) pouvant être fermée peut être ouverte et fermée à l'aide de la grue (3).

5. Navire selon l'une quelconque des revendications précédentes,
**caractérisé en ce que** la grue (3) est configurée afin de déplacer, en particulier de décaler, l'au moins un moteur (8, 9) à l'intérieur ou à l'extérieur du navire (1), de le soulever sur une plate-forme du navire (1) ou sur une plate-forme en dehors du navire (1).

6. Navire selon l'une quelconque des revendications précédentes,
**caractérisé en ce que** les moteurs (8, 9) présentent des points à attache (26, 27) et/ou sont fixés au niveau du navire (1) au moyen d'un système d'assemblage (35, 36, 37, 38) pouvant être détaché.

7. Navire selon l'une quelconque des revendications précédentes,
**caractérisé en ce que** les moteurs (8, 9) sont disposés sur un système de rails (41) de sorte que les moteurs (8, 9) peuvent être déplacés dans l'espace intérieur du navire (1).

8. Navire selon l'une quelconque des revendications précédentes,
**caractérisé en ce que** l'unité servant à transmettre la puissance est un arbre (11), et **en ce que** l'au moins un premier et deuxième moteur (8, 9) et l'unité de propulsion (50) sont disposés sur ledit arbre (11).

9. Navire selon la revendication 8,
**caractérisé en ce que** des systèmes de couplage (12, 13) sont disposés sur l'arbre (11) entre l'au moins un premier et deuxième moteur électrique (8, 9) et/ou entre les moteurs électriques (8, 9) et l'unité de propulsion (50).

10. Navire selon l'une quelconque des revendications précédentes,
**caractérisé en ce que** les moteurs électriques (8, 9) sont réalisés sous la forme de moteurs annulaires pourvus d'un rotor rotatif à l'intérieur et d'une bague de stator située côté extérieur dans une direction radiale.

11. Navire selon l'une quelconque des revendications précédentes,
**caractérisé en ce que** les moteurs électriques (8, 9) présentent essentiellement une structure identique.

12. Navire selon l'une quelconque des revendications précédentes,
**caractérisé en ce que** les moteurs électriques (8, 9) présentent un dispositif de refroidissement (19, 20), qui est en particulier un dispositif de refroidissement à air et/ou un dispositif de refroidissement à eau.

13. Navire selon l'une quelconque des revendications précédentes,
**caractérisé en ce que** les convertisseurs (15, 16) présentent un dispositif de refroidissement (31, 33), qui est en particulier un dispositif de refroidissement à air et/ou un dispositif de refroidissement à eau.

14. Procédé servant à remplacer des moteurs de navire (8, 9), qui sont disposés, conjointement avec des appareils périphériques, à l'intérieur d'un navire (1) afin d'entraîner le navire (1), qui sont couplés à une unité de propulsion (50) et qui sont fixés au niveau du navire (1) par un système d'assemblage (35, 36, 37, 38) pouvant être détaché, dans lequel le navire (1) est un navire selon la revendication 1,
**caractérisé par** les étapes suivantes consistant à :
- découpler au moins un moteur (8, 9) de l'unité de propulsion (50) de l'au moins un autre moteur (8, 9) ;
- découpler au moins un moteur (8, 9) des appareils périphériques,
- détacher le système d'assemblage (35, 36, 37, 38) pouvant être détaché d'au moins un moteur (8, 9) avec le navire (1) ;
- ouvrir l'ouverture (5) pouvant être fermée du navire (1),
- amener en prise la grue (3) avec l'au moins un moteur (8, 9) découplé et détaché ;
- retirer ou décaler le moteur (8, 9) au moyen de la grue (3).

15. Procédé selon la revendication 14,
**caractérisé en ce que** les quatre premières étapes sont réalisées selon un ordre inversé.

16. Procédé selon la revendication 14,
**caractérisé en ce que** le procédé présente en supplément l'étape consistant à :
- soulever et monter ou décaler un moteur (8, 9) au moyen de la grue (3) ; et/ou
- fermer l'ouverture (5) pouvant être fermée.

17. Utilisation d'un générateur d'éolienne, dans laquelle le générateur fonctionne de manière motorisée, en tant que moteur (8, 9) dans un navire (1) selon les revendications 1 à 8 ou dans un procédé selon les revendications 14 à 16.
